# EUROPEAN PATENT SPECIFICATION

(11) **EP 4 044 228 B1**
(45) Date of publication and mention of the grant of the patent: **31.07.2024**
(21) Application number: 22154721.9
(22) Date of filing: 02.02.2022
(51) Int. Cl.: H01L 25/16, H01L 25/11, H01L 23/538, H01L 23/498, H01L 23/373

(54) **POWER STRUCTURE, PREPARATION METHOD, AND DEVICE**
LEISTUNGSSTRUKTUR, HERSTELLUNGSVERFAHREN UND VORRICHTUNG
STRUCTURE D'ALIMENTATION, PROCÉDÉ DE PRÉPARATION ET DISPOSITIF

(30) Priority: 10.02.2021 CN 202110184049
(43) Date of publication of application: 17.08.2022
(73) Proprietor: HUAWEI TECHNOLOGIES CO., LTD., Shenzhen, Guangdong 518129, P.R. (CN)
(72) Inventor: ZHANG, Kai, Shenzhen, 518129 (CN); XU, Jiahui, Shenzhen, 518129 (CN); CHEN, Baiyou, Shenzhen, 518129 (CN); YAO, Weiwei, Shenzhen, 518129 (CN)
(74) Representative: Gill Jennings & Every LLP

(56) References cited:
- US-A1- 2012 068 332
- US-A1- 2019 043 847
- US-A1- 2019 088 621
- US-A1- 2020 058 695

## Description

### TECHNICAL FIELD

This application relates to the field of circuit technologies, and in particular, to a power structure, a preparation method, and a device.

### BACKGROUND

In power supply management, a plurality of requirements of a user continuously need to be satisfied. For example, the user needs more functions and higher performance, or the user requires a reduction in a geometric dimension of a power supply product to obtain a smaller power supply product. The plurality of requirements of the user conflict with each other sometimes. Therefore, a better power supply solution is required, for example, in aspects of conversion efficiency, a transient response, and noise power density, to meet a strict performance requirement and an outline dimension requirement of a final product.

The power supply product may be applied to a plurality of fields, for example, a data center power supply, an adapter power supply, and an inverter power supply. For example, the power supply product may be a power supply in package (power supply in package, PSiP). The PSiP may provide better performance without a compromise in the aspects of the conversion efficiency, the transient response, and the noise power density.

The power supply product imposes a higher requirement on power and an application frequency, so that the power supply product continuously evolves into a power supply product with high power, a high frequency, and high power density. For example, the PSiP continuously evolves into a PSiP with high power, a high frequency, and high power density.

A current power supply product cannot achieve an integration degree required in the industry, and cannot adapt to a development trend of product miniaturization. In addition, the current power supply product has a large parasitic parameter, and cannot meet a requirement of the high-frequency (a value of the frequency is at least in a unit of megahertz) and high-power field.

US 2019/088621 relates in general to semiconductor devices and, more particularly, to a semiconductor device and method of forming an embedded die substrate (EDS), and system-in-package (SiP) modules with the EDS. US 2019/043847 discloses a connection system of a semiconductor package, and more particularly, to a system in which a plurality of semiconductor packages are connected to each other using a printed circuit board. US 2020/058695 discloses a multi-chip packaging structure includes a first substrate having a first surface and a second surface, where the first substrate has a conductive layer portion. US 2012/068332 discloses an integrated circuit packaging system, and more particularly to a system with post.

### SUMMARY

Embodiments of this application provide a power structure, a preparation method, and a device, to provide a power structure with a high integration degree, to meet a requirement of the high-frequency and high-power field.

To resolve the foregoing technical problem, the embodiments of this application provide the following technical solutions.

The invention discloses a power structure according claim 1 and a power structure preparation method according to claim 7.

It can be learned from the foregoing technical solutions that the embodiments of this application have the following advantages:
In the embodiments of this application, the power structure includes the first substrate, the second substrate, the driver chip, the power chip, and the conductive part. The first substrate has the first surface, the second substrate has the second surface, the first surface and the second surface are disposed opposite to each other, and the power chip is disposed on the second substrate, so that the power chip is located between the first substrate and the second substrate. In addition, the driver chip is disposed on the first substrate. Therefore, the power chip and the driver chip are disposed on the two substrates, and the power chip and the driver chip belong to a structure in which the two substrates are stacked, to improve an integration degree of the power structure. The conductive part has a first end and a second end. The first end is connected to the first surface, and the second end is connected to the second surface. The conductive part may connect the first substrate and the second substrate. The conductive part electrically connects the first substrate and the second substrate, and the conductive part may be used to implement electrical transmission between the first substrate and the second substrate, to decrease a parasitic parameter of the power structure, and meet a requirement of the high-frequency and high-power field.

In the embodiments of this application, the second substrate has the second surface, the power chip is located on the second surface, and the first substrate is stuck on the first package body by using the adhesive film, so that the power chip is located between the first substrate and the second substrate. In addition, the driver chip is disposed on the first substrate. Therefore, the power chip and the driver chip are disposed on the two substrates, and the power chip and the driver chip belong to a structure in which the two substrates are stacked, to improve an integration degree of the power structure. Two ends of the conducting wire are respectively connected to the first substrate and the second substrate, and the conducting wire may be used to implement electrical transmission between the first substrate and the second substrate, to decrease a parasitic parameter of the power structure, and meet a requirement of the high-frequency and high-power field.

### BRIEF DESCRIPTION OF DRAWINGS

FIG. 1 is a schematic diagram of a structure of a power structure according to an embodiment of this application;
FIG. 2 is a schematic diagram of a structure of a power structure including two conductive parts according to an embodiment of this application;
FIG. 3 is a schematic diagram of a structure of a power structure including a package body according to an embodiment of this application;
FIG. 4 is a schematic diagram of a structure of a power structure including solder according to an embodiment of this application;
FIG. 5 is a schematic diagram of a structure of a power structure including one first electronic element according to an embodiment of this application;
FIG. 6 is a schematic diagram of a structure of a power structure including a plurality of first electronic elements according to an embodiment of this application;
FIG. 7 is a schematic diagram of a structure of a power structure including one second electronic element according to an embodiment of this application;
FIG. 8 is a schematic diagram of a structure of a power structure including a plurality of second electronic elements according to an embodiment of this application;
FIG. 9 is a schematic diagram of a structure of a power structure including a ceramic layer and a copper layer according to an embodiment of this application;
FIG. 10 is a schematic diagram of a structure of a power structure including a heat dissipation module according to an embodiment of this application;
FIG. 11 is a schematic diagram of a structure of a power structure including a pad according to an embodiment of this application;
FIG. 12 is a schematic diagram of a structure of a power structure including a first embedded substrate according to an embodiment of this application;
FIG. 13 is a schematic diagram of a structure of a power structure including a second power chip according to an embodiment of this application;
FIG. 14 is a schematic diagram of a structure of a power structure including a third electronic element according to an embodiment of this application;
FIG. 15 is a schematic diagram of a structure of a power structure including a second power chip according to an embodiment of this application;
FIG. 16 is a schematic diagram of a structure in which a first power chip is assembled on a second substrate according to an embodiment of this application;
FIG. 17 is a schematic diagram of a structure in which a driver chip and a conductive part are assembled on a first substrate according to an embodiment of this application;
FIG. 18 is a schematic diagram of a structure of another power structure according to an embodiment of this application;
FIG. 19 is a schematic diagram of a structure of a power structure including a second package body and a first package body according to an embodiment of this application;
FIG. 20 is a schematic diagram of a structure of a power structure including a conductive part according to an embodiment of this application;
FIG. 21 is a schematic diagram of a structure of a power structure including a first electronic element according to an embodiment of this application;
FIG. 22 is a schematic diagram of a structure of a power structure including a second electronic element according to an embodiment of this application;
FIG. 23 is a schematic diagram of a structure of a power structure including a heat dissipation module according to an embodiment of this application;
FIG. 24 is a schematic diagram of a structure of a power structure including a first embedded substrate according to an embodiment of this application;
FIG. 25 is a schematic diagram of a structure of a power structure including a second power chip according to an embodiment of this application;
FIG. 26 is a schematic diagram of a structure of a power structure including a third electronic element according to an embodiment of this application;
FIG. 27 is a schematic diagram of a structure of a power structure including a fourth electronic element according to an embodiment of this application;
FIG. 28 is a schematic diagram of a structure of a power structure including a third power chip according to an embodiment of this application;
FIG. 29 is a schematic diagram of a power structure preparation method according to an embodiment of this application;
FIG. 30 is a schematic diagram of a structure in which a first power chip is assembled on a second substrate according to an embodiment of this application; and
FIG. 31 is a schematic diagram of a structure in which a first package body is packaged on a second substrate according to an embodiment of this application.

In addition, in the accompanying drawings of this application, reference numerals are as follows, and a reference numeral of each apparatus component is not referenced in subsequent specific implementations:
first substrate 101;
first surface 1011 of the first substrate;
second substrate 102;
second surface 1021 of the second substrate;
driver chip 103;
first power chip 104;
conductive part 105;
first end 1051 of a conductive part;
second end 1052 of the conductive part;
package body 106;
first solder 1071;
second solder 1072;
first electronic element 108;
second electronic element 109;
heat dissipation module 110;
ceramic layer 1022 of the second substrate;
copper layer 1023 of the second substrate;
third surface 1024 of the second substrate;
fourth surface 1012 of the first substrate;
pad 111;
second power chip 112;
third electronic element 113;
third power chip 114;
conducting wire 115;
second package body 116;
first package body 117;
adhesive film 118; and
fourth electronic element 119.

### DESCRIPTION OF EMBODIMENTS

Embodiments of this application provide a power structure, a preparation method, and a device, to provide a power structure with a high integration degree, to meet a requirement of the high-frequency and high-power field.

The following describes the embodiments of this application with reference to the accompanying drawings.

In the specification, claims, and the accompanying drawings of this application, the terms "first", "second", and the like are intended to distinguish between similar objects but do not necessarily indicate a specific order or sequence. It should be understood that the terms used in this manner may be changed in a proper case, which is merely a discrimination manner that is used when objects having a same attribute are described in the embodiments of this application. For example, a first substrate and a second substrate represent two different substrates, and the first substrate and the second substrate are independent of each other. If "first" is not recorded, "second" may be recorded in the embodiments. Similarly, if "first" is recorded in the embodiments, "second" may not be recorded. In addition, the terms "include", "have" and any other variants thereof mean to cover the non-exclusive inclusion, so that a process, method, system, product, or device that includes a series of units is not necessarily limited to those units, but may include other units not expressly listed or inherent to such a process, method, system, product, or device.

An embodiment of this application provides a power structure. The power structure is a component structure unit including a power chip. For example, the power structure may be a power module, a power component, or a power structure unit. In this embodiment of this application, the power structure may also be defined as a structure unit with another name. For example, the power structure may be a module, an apparatus, a device, a terminal, or a component. A specific implementation is not limited. The power structure provided in this embodiment of this application includes a power chip. The power chip may also be referred to as a "power semiconductor chip", and the power chip is a chip that can generate power in a powered-on state. A specific implementation of the power chip is related to an application scenario of the power structure. For different power structures, a type of the power chip included in the power structure, a quantity of power chips, an arrangement manner of the power chip in the power structure, and a manner of connecting the power chip and another electronic element and another chip in the power structure need to be determined with reference to a specific application scenario of the power structure. For example, the power structure may be a power supply in package (power supply in package, PSiP), and the power chip may be a metal-oxide-semiconductor field-effect transistor (metal-oxide-semiconductor field-effect transistor, MOSFET).

The following first describes terms related to components of the power structure in this embodiment of this application.

The power structure provided in this embodiment of this application includes a dual substrate, a driver chip, a power chip, and a conductive part. The substrate in this embodiment of this application may be a printed circuit board (printed circuit board, PCB). The dual substrate includes two substrates, and the two substrates are respectively defined as a first substrate and a second substrate. The first substrate and the second substrate may be two substrates disposed opposite to each other. There is space between the two substrates. To be specific, there is a distance between the two substrates. A value of the distance between the two substrates is not limited herein. The first substrate and the second substrate each are a substrate having a circuit function, and the first substrate and the second substrate are further configured to fasten a chip. According to distribution locations of the first substrate and the second substrate in the space, one of the first substrate and the second substrate may be referred to as an upper substrate, and the other substrate in the first substrate and the second substrate may be referred to as a lower substrate. For ease of description, the first substrate may be a lower substrate, and the second substrate may be an upper substrate in a subsequent embodiment. The upper substrate and the lower substrate are defined based on the distribution locations of the substrates in the space, and are not intended to limit this embodiment of this application.

In some embodiments of this application, the second substrate may be a substrate having a heat dissipation function. For example, the second substrate may be a direct bonding copper (direct bonding copper, DBC). For example, the DBC includes a ceramic layer and a copper layer. The DBC is a substrate made by directly sintering copper foil on a ceramic surface. The DBC may be used for a high-power semiconductor module, a power control circuit, a power hybrid circuit, an intelligent power module, a high-frequency switching power supply, a solid-state relay, a solar cell module, or the like.

In some embodiments of this application, the driver chip may be disposed on the first substrate. For example, the driver chip may be disposed on a surface of the first substrate. For another example, the first substrate may be an embedded substrate. In the embedded substrate, an electronic element and a chip (for example, the driver chip or the power chip) are built inside the substrate through embedded component packaging (embedded component packaging, ECP).

In this embodiment of this application, the power structure includes the driver chip. The driver chip is a chip component configured to drive the power chip. The driver chip stores a driver program. After the driver chip is powered on and runs, the driver chip may run the driver program, to drive, by using the driver program, the power chip to run.

In this embodiment of this application, the power structure includes one or more power chips. Specifically, the power chip in the power structure needs to be determined with reference to an application scenario. For example, the power structure includes a first power chip. The first power chip and the driver chip are respectively disposed on different substrates in the power structure. The power structure includes the dual substrate, and the first power chip and the driver chip each are disposed on one substrate. It can be learned from the foregoing description of the dual substrate that the two substrates in the dual substrate are disposed opposite to each other, and the first power chip and the driver chip are disposed on different substrates, so that the first power chip and the driver chip are not distributed on a same plane. The first power chip and the driver chip are distributed on different planes. Therefore, the power structure provided in this embodiment of this application is a three-dimensional structure. In this distribution manner of the first power chip and the driver chip, an integration degree of the power structure can be improved, to reduce a space volume of the power structure, and adapt to a development trend of device miniaturization.

In some embodiments of this application, the power structure includes the first power chip and the second power chip, and the first power chip and the second power chip are located on different substrates.

In this embodiment of this application, the power structure includes the conductive part, and the conductive part may electrically connect the first substrate and the second substrate. In other words, the conductive part may be used to interconnect the two substrates in the dual substrate, so that electrical transmission can be performed between chips that are respectively mounted on the two substrates in the dual substrate. For example, the conductive part may be used to implement signal transmission between the chips that are respectively mounted on the two substrates in the dual substrate.

In some embodiments of this application, a material of the conductive part may be copper or another conductive metal material. This is not limited herein. In addition, the conductive part provided in this embodiment of this application has a plurality of shapes. It only needs to be ensured that the conductive part can implement a function of interconnecting the two substrates in the dual substrate. For example, the conductive part is in one of the following shapes: a column shape, a plate shape, a sheet shape, and the like. For example, a cross section of the conductive part has a plurality of shapes. For example, the cross section of the conductive part may be L-shaped, square-shaped, circular, or rhombic.

In some embodiments of this application, the conductive part may have a support function in addition to a conduction function. For example, the conductive part is supported between the two substrates in the dual substrate, to form space of a specific size between the two substrates in the dual substrate. All components in the power structure may be accommodated in the space.

In some embodiments of this application, the power structure may include one or more package bodies. When the power structure includes a plurality of package bodies, for example, includes two package bodies, the two package bodies are respectively defined as a second package body and a first package body. The chip in the power structure needs to be packaged, to obtain a package body. The package body may be used to package a surface of a substrate, the power chip, the driver chip, and the conductive part. The package body is an enclosure for mounting a semiconductor integrated circuit chip, and may be used to place, fasten, seal, and protect the chip, and enhance thermal conductivity. For example, the package body may be a molded body obtained by molding the surface of the substrate, the power chip, the driver chip, and the conductive part. For example, the package body may be a package layer.

In some embodiments of this application, the power structure may include an electronic element, and the electronic element is a required component in the power structure. For example, there may be one or more electronic elements in the power structure. For example, the electronic element may be at least one of the following components: a resistor, a capacitor, and an inductor. An implementation of the electronic element is not limited in this embodiment of this application. When the power structure includes a plurality of electronic elements, for example, includes two electronic elements, the two electronic elements are respectively defined as a first electronic element and a second electronic element. Deployment locations and functions of the first electronic element and the second electronic element in the power structure are different. For details, refer to example descriptions in a subsequent embodiment.

In some embodiments of this application, the second substrate is a substrate having a heat dissipation function. For example, a heat dissipation module is disposed on the second substrate, and the heat dissipation module may be configured to dissipate heat for the power chip. For example, the heat dissipation module can provide a heat dissipation channel for the chip assembled on the upper substrate. In this embodiment of this application, the heat dissipation module includes but is not limited to a heat dissipation material, or the heat dissipation channel is disposed on the heat dissipation module.

The foregoing content describes components of the power structure in this embodiment of this application. The power structure provided in this embodiment of this application is described below with reference to the accompanying drawings.

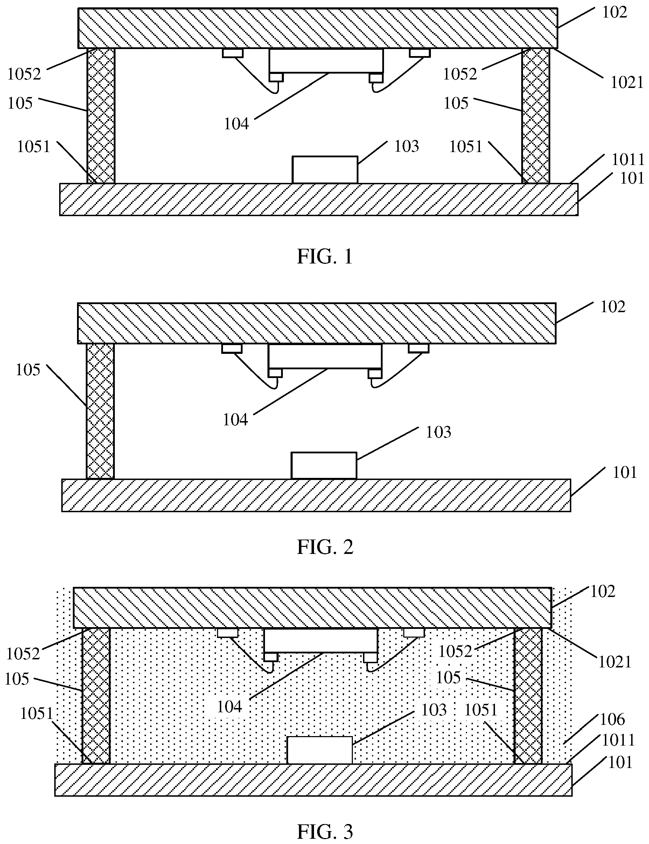

Refer to FIG. 1. A power structure provided in an embodiment of this application includes a first substrate, a second substrate, a driver chip, a power chip, and a conductive part.

A first surface of the first substrate and a second surface of the second substrate are disposed opposite to each other.

A first end of the conductive part is connected to the first surface, and a second end of the conductive part is connected to the second surface.

The driver chip is disposed on the first substrate.

The power chip is disposed on the second substrate.

In some embodiments of this application, to distinguish between a plurality of power chips in this embodiment of this application, the power chip in "the power chip is disposed on the second substrate" is referred to as a first power chip. For example, the first power chip is located on the second surface and faces the first surface.

There is specific space between the first substrate and the second substrate in FIG. 1, and the conductive part plays a conduction role and a support role. The first surface of the first substrate is a main surface on which a chip is disposed. For example, the first surface of the first substrate faces upwards.

In some embodiments of this application, as shown in FIG. 1, the driver chip is disposed on the first substrate. For example, the driver chip is located on the first surface and faces the second surface. The second surface of the second substrate is a main surface on which a chip is disposed. For example, the second surface of the second substrate faces downwards. There is space between the first surface and the second surface, and the driver chip and the first power chip are disposed between the first substrate and the second substrate. For example, the first power chip may be connected to the second substrate by using solder. The conductive part has the first end and the second end, the first end and the second end are an upper end and a lower end of the conductive part, the first end is connected to the first surface, and the second end is connected to the second surface, so that the conductive part can electrically connect the first substrate and the second substrate. In the power structure shown in FIG. 1, the driver chip and the first power chip are disposed on different planes. The power structure is a three-dimensional structure. The conductive part may electrically connect the first substrate and the second substrate, to shorten a transmission path between the first substrate and the second substrate, and decrease a parasitic parameter of the power structure. Based on the power structure shown in FIG. 1, device miniaturization and a high integration degree of the power structure can be realized.

In some embodiments of this application, the driver chip is disposed on the first surface of the first substrate or built in the first substrate; and the power chip is disposed on the second surface of the second substrate. For example, the driver chip is located on the first surface and faces the second surface. For another example, the driver chip may be built in the first substrate. For details, refer to the description in a subsequent embodiment. In the foregoing solution, the driver chip and the power chip are disposed between the first substrate and the second substrate, the driver chip and the power chip are disposed on different planes, and the power structure is a three-dimensional structure. Device miniaturization and a high integration degree of the power structure can be realized.

It should be noted that in this embodiment of this application, a quantity of conductive parts in the power structure and a distribution location of the conductive parts are not limited, a quantity of driver chips in the power structure and a distribution location of the driver chips are not limited, and a quantity of first power chips in the power structure and a distribution location of the first power chips are not limited. Specifically, these may be determined with reference to an application scenario, and merely example descriptions are used herein. In FIG. 1, the power structure includes two conductive parts, and each of the two conductive parts plays a conduction role and a support role for the first substrate and the second substrate. For example, the two conductive parts have a left-right symmetrical structure.

As shown in FIG. 2, the power structure includes one conductive part, and the one conductive part plays a conduction role and a support role for the first substrate and the second substrate. In this embodiment of this application, the power structure may alternatively include another quantity of conductive parts. This is not limited.

In some embodiments of this application, as shown in FIG. 3, the power structure further includes a package body.

The package body covers the first surface of the first substrate, the second substrate, the driver chip, the power chip, and the conductive part.

The package body is used to package an internal structure of the power structure. For example, the package body is used to package the first surface of the first substrate, the second surface, the driver chip, the power chip, and the conductive part, to obtain a packaged power structure. That the package body covers the second substrate may be that the package body covers one or more surfaces of the second substrate. For example, the package body covers the first surface of the first substrate, the second surface of the second substrate, the driver chip, the power chip, and the conductive part. For another example, the package body covers the second surface and a side face of the second substrate. For another example, the package body is used to package the space between the first substrate and the second substrate. The driver chip, the first power chip, and the conductive part are all packaged in the package body, to obtain a sealed power structure. For example, the power structure may be a three-dimensional high-density packaging structure in which two substrates in a dual substrate are interconnected by using the conductive part.

In some embodiments of this application, the conductive part electrically connects the first substrate and the second substrate. In addition, the conductive part further may play a support role for the substrate. The conductive part is located between the first surface and the second surface. The conductive part may be a conductive pillar, and the conductive pillar is located between the first surface and the second surface. In this embodiment of this application, the conductive part may play a support role in addition to a conduction role, so that the power chip and the driver chip may be disposed in the space between the first substrate and the second substrate. For another example, the power structure further includes an electronic element, and the electronic element may also be disposed in the space between the first substrate and the second substrate.

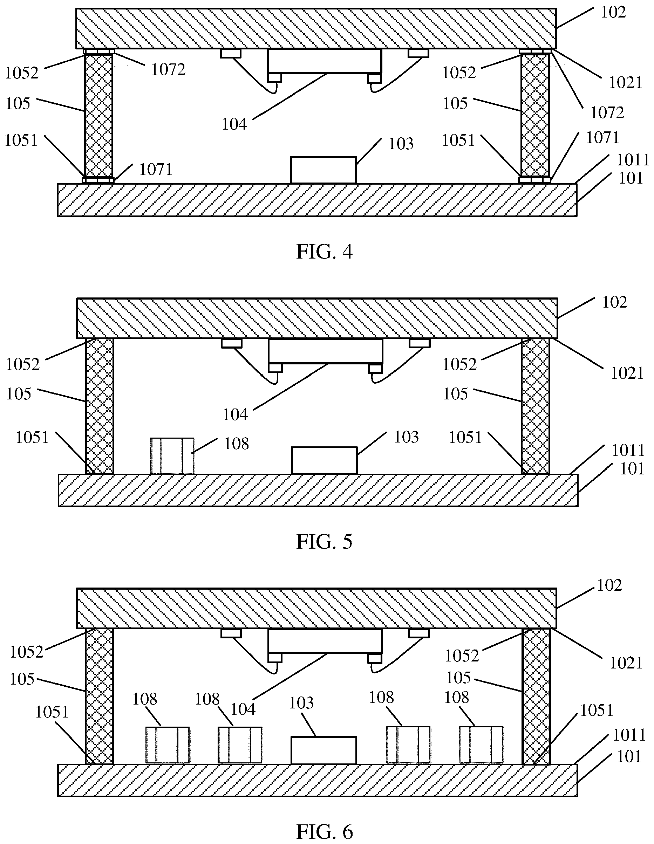

In some embodiments of this application, the power structure further includes solder. The first end is soldered to the first surface by using solder, and the second end is soldered to the second surface by using solder. For ease of description and illustration, based on different locations on which the solder is used, the solder is respectively referred to as first solder and second solder. As shown in FIG. 4, the first end is connected to the first surface by using the first solder, and the second end is connected to the second surface by using the second solder. Therefore, the conductive part may be connected to the first substrate and the second substrate by using solder, and the conductive part may be fastened to the first substrate and the second substrate by using solder, to form the space between the first substrate and the second substrate.

In some embodiments of this application, the power structure further includes an electronic element; and the electronic element is disposed on the first surface of the first substrate and/or the second surface of the second substrate. For ease of description and illustration, based on different distribution locations and connection relationships of the electronic element, the electronic element is respectively referred to as a first electronic element, a second electronic element, a third electronic element, and the like. For example, the electronic element is specifically the first electronic element. As shown in FIG. 5, the power structure further includes the first electronic element.

The first electronic element is disposed on the first surface and faces the second surface.

The first electronic element and the driver chip may be disposed side by side on the first surface of the first substrate, the first electronic element may be disposed in the space between the first substrate and the second substrate, and the first electronic element and the first power chip may be distributed on different planes. Therefore, the power structure is a three-dimensional structure, to facilitate a miniaturization design of the power structure. A quantity of first electronic elements is not limited in this embodiment of this application.

It should be noted that, when the power structure further includes the first electronic element, the package body covers the first surface of the first substrate, the second substrate, the driver chip, the first power chip, the conductive part, and the first electronic element.

In some embodiments of this application, as shown in FIG. 6, description is provided by using an example in which the power structure includes four first electronic elements. The four first electronic elements and the driver chip may be disposed side by side. A distribution manner of the four first electronic elements on the first surface of the first substrate is not limited. In addition, types of the four first electronic elements are not limited.

It should be noted that, when the power structure further includes four first electronic elements, the package body covers the first surface of the first substrate, the second substrate, the driver chip, the first power chip, the conductive part, and the four first electronic elements.

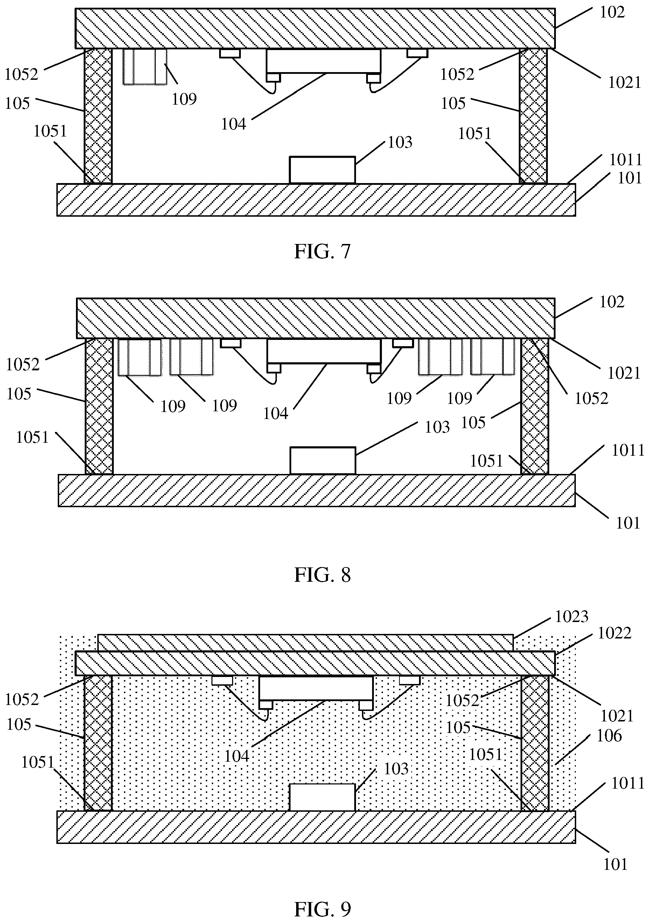

In some embodiments of this application, as shown in FIG. 7, the power structure further includes the second electronic element.

The second electronic element is disposed on the second surface and faces the first surface.

The second electronic element and the first power chip may be disposed side by side on the second surface of the second substrate, the second electronic element may be disposed in the space between the first substrate and the second substrate, and the second electronic element and the driver chip may be distributed on different planes. Therefore, the power structure is a three-dimensional structure, to facilitate a miniaturization design of the power structure. A quantity of second electronic elements is not limited in this embodiment of this application.

It should be noted that, when the power structure further includes the second electronic element, the package body covers the first surface of the first substrate, the second substrate, the driver chip, the first power chip, the conductive part, and the second electronic element.

It should be noted that a difference between FIG. 7 and FIG. 5 lies in different distribution locations of electronic elements. For example, the first electronic element is distributed on the first substrate, and the second electronic element is distributed on the second substrate.

In some embodiments of this application, as shown in FIG. 8, description is provided by using an example in which the power structure includes four second electronic elements. The four second electronic elements and the driver chip may be disposed side by side. A distribution manner of the four second electronic elements on the second surface of the second substrate is not limited. In addition, types of the four second electronic elements are not limited.

It should be noted that, when the power structure further includes four second electronic elements, the package body covers the first surface of the first substrate, the second substrate, the driver chip, the first power chip, the conductive part, and the four second electronic elements.

In some embodiments of this application, as shown in FIG. 9, the second substrate may be a substrate having a heat dissipation function. For example, the second substrate may be a DBC. For example, the DBC includes a ceramic layer and a copper layer. The ceramic layer may be packaged in the package body, and a surface of the copper layer is not packaged in the package body. Therefore, the DBC may implement the heat dissipation function.

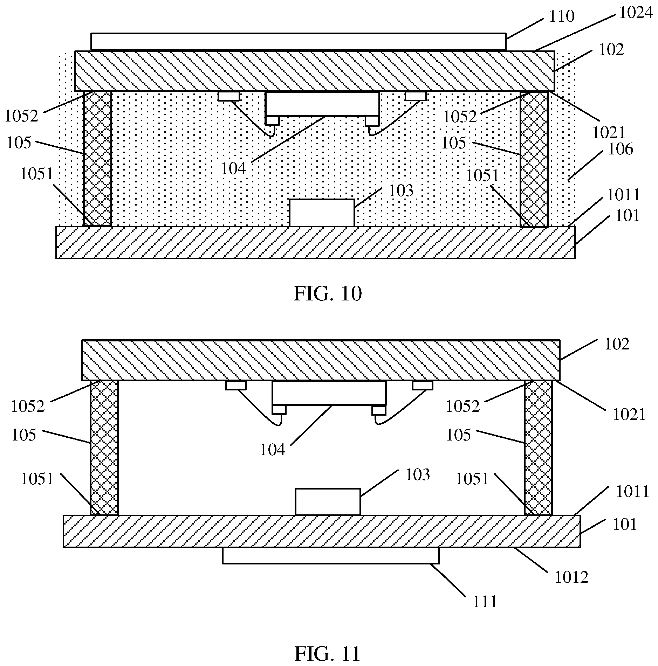

In some embodiments of this application, as shown in FIG. 10, the power structure further includes a heat dissipation module.

The heat dissipation module is disposed on a rear face of the second surface of the second substrate.

For example, the second substrate has a third surface, the second surface and the third surface of the second substrate are two opposite surfaces, and the third surface of the second substrate is an opposite face of the second substrate. For example, the third surface is used to dispose the heat dissipation module. The first power chip and the heat dissipation module are respectively disposed on different surfaces of the second substrate. The first power chip is packaged in the package body, but the heat dissipation module is not packaged in the package body. Therefore, the heat dissipation module may be configured to dissipate heat for the power structure. For example, the power structure may be a three-dimensional high-density and high-thermal conductivity packaging structure in which two substrates in a dual substrate are interconnected by using the conductive part.

In some embodiments of this application, as shown in FIG. 11, the power structure further includes a pad.

The pad is located on a fourth surface of the first substrate.

The fourth surface is a rear face of the first surface.

The fourth surface and the first surface of the first substrate are two opposite surfaces, and the fourth surface of the first substrate is an opposite face of the first substrate. For example, the fourth surface is used to dispose the pad. The driver chip and the pad are respectively disposed on different surfaces of the first substrate, the driver chip is packaged in the package body, the pad is not packaged in the package body, and the pad may be used for an electrical connection between the power structure and another external device. In this embodiment of this application, a distribution location of the pad on the fourth surface and a quantity of pads are not limited.

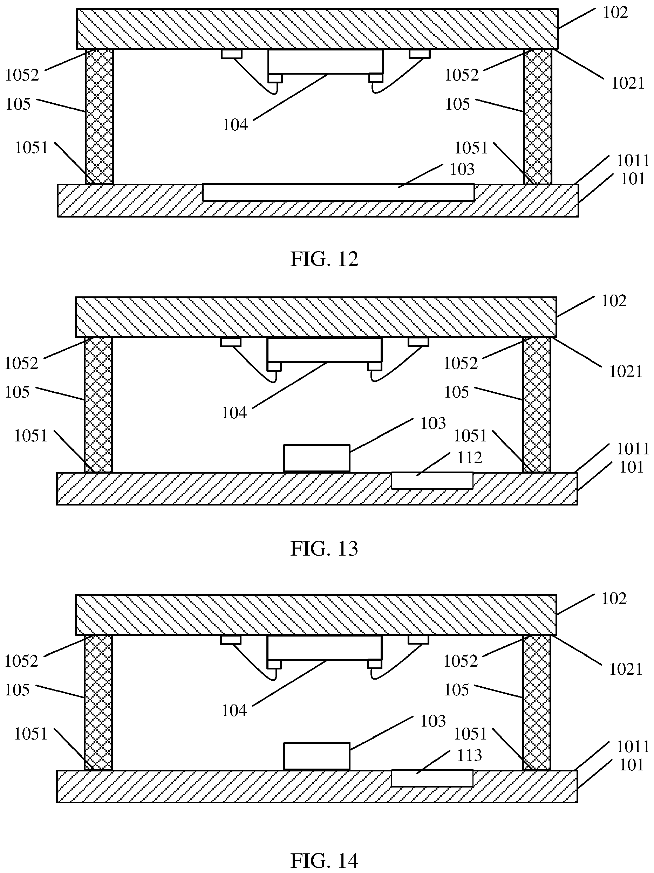

In some embodiments of this application, the driver chip may be built in the first substrate. For example, as shown in FIG. 12, the first substrate is a first embedded substrate.

The driver chip is disposed in the first embedded substrate.

As shown in FIG. 12, the driver chip is built in the first embedded substrate. Therefore, only the first power chip and the conductive part need to be disposed between the first embedded substrate and the second substrate, to further reduce a volume of the power structure, and facilitate a miniaturization design of the power structure.

In some embodiments of this application, the power chip may be built in the first substrate. For example, as shown in FIG. 13, the power structure further includes a second power chip.

The first substrate is a second embedded substrate.

The second power chip is disposed in the second embedded substrate.

As shown in FIG. 13, the driver chip may be disposed on the first surface of the second embedded substrate, and the second power chip is disposed in the second embedded substrate. Therefore, only the first power chip, the conductive part, and the driver chip need to be disposed between the second embedded substrate and the second substrate, to further reduce a volume of the power structure, and facilitate a miniaturization design of the power structure.

It should be noted that a difference between FIG. 12 and FIG. 13 lies in that the embedded substrate includes different embedded units. For example, the driver chip is disposed in the first embedded substrate in FIG. 12, and the second power chip is disposed in the second embedded substrate in FIG. 13. The driver chip and the second power chip may alternatively be built simultaneously in the embedded substrate in the power structure. This is not limited herein.

In some embodiments of this application, the electronic element may be built in the first substrate. For example, as shown in FIG. 14, the power structure further includes a third electronic element.

The first substrate is a third embedded substrate.

The third electronic element is disposed in the third embedded substrate.

In FIG. 14, the driver chip may be disposed on the first surface of the third embedded substrate, and the third electronic element is disposed in the third embedded substrate. Therefore, only the first power chip, the conductive part, and the driver chip need to be disposed between the third embedded substrate and the second substrate, to further reduce a volume of the power structure, and facilitate a miniaturization design of the power structure.

It should be noted that a difference between FIG. 13 and FIG. 14 lies in that the embedded substrate includes different embedded units. For example, the second power chip is disposed in the second embedded substrate in FIG. 13, and the third electronic element is disposed in the third embedded substrate in FIG. 14. The second power chip and the third electronic element may alternatively be built simultaneously in the embedded substrate in the power structure. This is not limited herein.

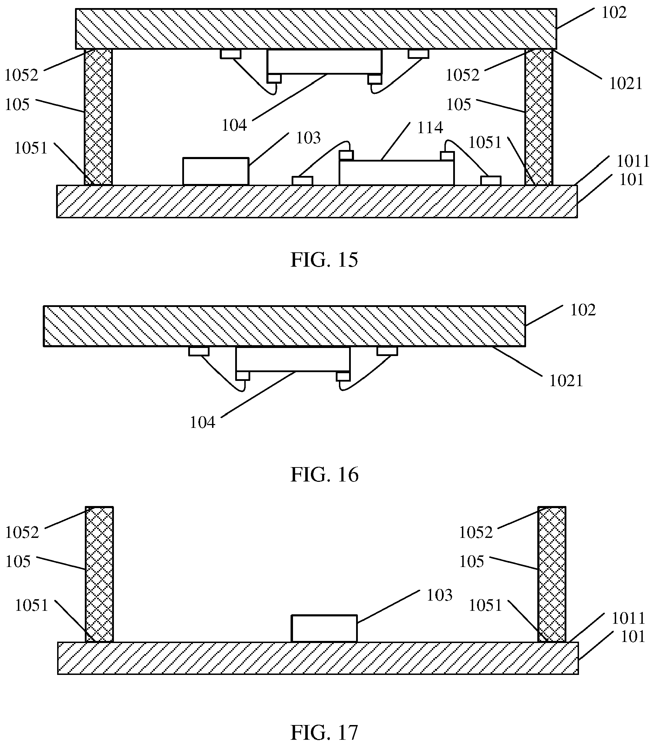

In some embodiments of this application, as shown in FIG. 15, the power structure further includes a third power chip.

The third power chip is located on the first surface and faces the second surface.

The power structure may include a plurality of power chips. For example, the power structure includes the first power chip and the third power chip, the first power chip is disposed on the second substrate, and the third power chip is disposed on the first substrate. The third power chip and the driver chip may be disposed side by side on the first surface of the first substrate, the third power chip may be disposed in the space between the first substrate and the second substrate, and the third power chip and the first power chip may be distributed on different planes. Therefore, the power structure is a three-dimensional structure, to facilitate a miniaturization design of the power structure.

The foregoing embodiment describes the power structure. The following describes an alternating current module provided in an embodiment of this application. The alternating current module includes the power structure shown in FIG. 1 to FIG. 15. The alternating current module has advantages of a small volume, a high integration degree, and a small parasitic parameter.

The following describes an energy device provided in an embodiment of this application. The energy device includes the power structure shown in FIG. 1 to FIG. 15; or
the energy device includes the foregoing alternating current module.

The energy device has advantages of a small volume, a high integration degree, and a small parasitic parameter.

The following describes a remote radio unit provided in an embodiment of this application. The remote radio unit includes the foregoing alternating current module. The remote radio unit has advantages of a small volume, a high integration degree, and a small parasitic parameter.

It can be learned from the example descriptions in the foregoing embodiments that a first substrate has a first surface, a second substrate has a second surface, the first surface and the second surface are disposed opposite to each other, and a power chip is disposed on the second substrate, so that the power chip is located between the first substrate and the second substrate. In addition, the driver chip is disposed on the first substrate. Therefore, the power chip and the driver chip are disposed on the two substrates, and the power chip and the driver chip belong to a structure in which the two substrates are stacked, to improve an integration degree of the power structure. A conductive part has a first end and a second end. The first end is connected to the first surface, and the second end is connected to the second surface. The conductive part may connect the first substrate and the second substrate. The conductive part electrically connects the first substrate and the second substrate, and the conductive part may be used to implement electrical transmission between the first substrate and the second substrate, to decrease a parasitic parameter of the power structure, and meet a requirement of the high-frequency and high-power field.

The power structure is described below by using an actual application scenario as an example.

The power structure provided in this embodiment of this application may be applied to a wireless 5G enhanced multiple-input multiple-output (multiple-input multiple-output) product, to improve a packaging integration degree of the power structure, and resolve problems of heat dissipation and a large parasitic parameter of a high-frequency and high-power device.

The power structure provided in this embodiment of this application is a three-dimensional high-density and high-thermal conductivity packaging structure in which two substrates in a dual substrate are interconnected by using the conductive part. A plurality of chips are stacked and molded, to improve a packaging integration degree. In addition, an upper substrate and a lower substrate are interconnected to shorten a signal transmission path. A heat dissipation structure is designed on the upper substrate in a stacking structure. The power structure is applicable to the high-frequency and high-power field.

As shown in FIG. 16 and FIG. 17, the power structure in this embodiment of this application includes: a lower substrate having a circuit function, an upper substrate having a heat dissipation function, a driver chip (or a chip having a driving function), a power chip, and a conductive pillar. Optionally, the power structure may further include another required electronic element and a package body.

Specifically, as shown in FIG. 16, a plurality of chips are assembled on the upper substrate. As shown in FIG. 17, the driver chip is mounted on one face of the lower substrate. As shown in FIG. 11, a pad is mounted on the other face of the lower substrate. In this case, an electrical connection between the power structure and another component is implemented, and another component may be assembled on the upper substrate and the lower substrate based on a requirement. As shown in FIG. 1, the upper substrate having the heat dissipation function and the lower substrate are interconnected by using the conductive pillar. Electrical transmission of a chip on the upper substrate is implemented by using the conductive pillar, and three-dimensional multi-chip stacking and molding are completed after molding.

The upper substrate has the heat dissipation function, and can provide a heat dissipation channel for a power chip assembled on the upper substrate. The upper substrate and the lower substrate are interconnected by using the conductive pillar, to shorten a signal transmission path, and decrease a parasitic parameter applied in the high-frequency field. In addition, the stacked power structure is used to further improve a packaging integration degree.

The upper substrate and the lower substrate are assembled by using the conductive pillar through snap-fitting, and a processing process of such a package form includes three parts: respective assembly of the upper substrate and the lower substrate and assembly of the dual substrate. For the assembly of the upper substrate and the lower substrate, a chip, a component, and a substrate are assembled by using an interconnection process, for example, D die attach (die attach), wire bonding (wire bonding), or a surface-mount technology (surface-mount technology, SMT). For the assembly of the dual substrate, an electrical connection between the upper substrate and a lower substrate is implemented by using the conductive pillar (for example, a copper pillar) and an interconnection structure (for example, solder). Finally, the power structure is formed through molding.

As shown in FIG. 10, to improve a heat dissipation effect, a heat dissipation module may be assembled on the upper substrate.

As shown in FIG. 12 and FIG. 13, to further improve a packaging integration degree, the lower substrate may be a substrate in which a chip or another electronic element is built.

In this embodiment of this application, the power structure is a dual-substrate three-dimensional packaging structure in which a plurality of chips are stacked, to improve packaging density, and reduce a packaging dimension. The upper substrate having the heat dissipation function provides a good heat dissipation channel, to resolve a difficulty of heat dissipation of three-dimensional packaging. In the packaging structure in which the upper substrate and the lower substrate are stacked, a parasitic parameter is decreased. An application extends to the high-frequency field. In addition, there is no direct signal transmission between the upper substrate and an outside, to play an electrical isolation role.

An embodiment of this application further provides a power structure. The power structure includes a first substrate, a second substrate, a driver chip, a power chip, and a conductive part.

A first surface of the first substrate and a second surface of the second substrate are disposed opposite to each other.

A first end of the conductive part is connected to the first surface, and a second end of the conductive part is connected to the second surface.

The power chip is disposed on the second substrate.

The driver chip is disposed on the second substrate.

The driver chip may be disposed on the second substrate. For example, the driver chip is located on the second surface and faces the first surface.

It can be learned from the example descriptions in the foregoing embodiments that the power structure includes the first substrate, the second substrate, the driver chip, the power chip, and the conductive part. The second substrate has the second surface, and the power chip is located on the second surface and faces the first surface, so that the power chip is located between the first substrate and the second substrate. In addition, the driver chip is disposed on the second substrate, to improve an integration degree of the power structure. The conductive part has the first end and the second end. The first end is connected to the first surface, and the second end is connected to the second surface. The conductive part may connect the first substrate and the second substrate. The conductive part electrically connects the first substrate and the second substrate, and the conductive part may be used to implement electrical transmission between the first substrate and the second substrate, to decrease a parasitic parameter of the power structure, and meet a requirement of the high-frequency and high-power field.

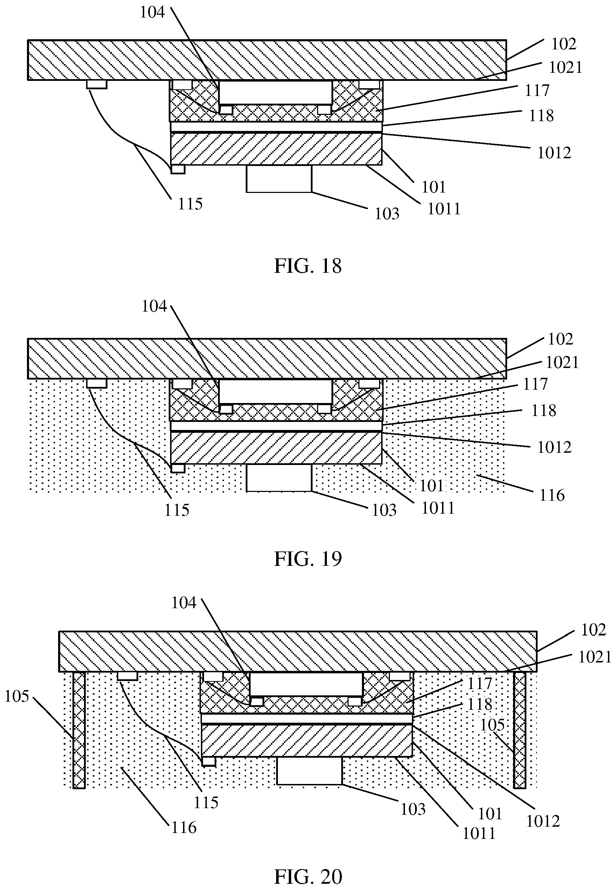

The foregoing embodiment describes the power structure provided in the embodiments of this application. The following describes another power structure provided in an embodiment of this application. As shown in FIG. 18, the power structure includes a first substrate, a second substrate, a driver chip, a power chip, a conducting wire, a first package body, and an adhesive film.

The power chip is located on a second surface of the second substrate.

The second surface and a first power chip are packaged by using the first package body.

The first substrate is stuck on the first package body by using the adhesive film.

The conducting wire is configured to electrically connect the first substrate and the second substrate.

The driver chip is disposed on the first substrate.

In some embodiments of this application, the power structure further includes a conductive part; and a first end of the conductive part is connected to the second surface of the second substrate. The first end of the conductive part is connected to the second surface of the second substrate, so that the second substrate can output an electrical signal by using the conductive part.

In some embodiments of this application, to distinguish between a plurality of power chips in this embodiment of this application, the power chip in "the power chip is located on a second surface of the second substrate" is referred to as the first power chip. For example, the first power chip is located on the second surface.

There is specific space between the first substrate and the second substrate in FIG. 18, and the conductive part plays a conduction role. The first surface is a surface that is of the first substrate and that is far away from the first package body. For example, the first surface of the first substrate faces downwards. The fourth surface is a surface that is of the first substrate and that is close to the first package body. For example, the fourth surface of the fourth substrate faces upwards. The second surface of the second substrate is a main surface on which a chip is disposed. For example, the second surface of the second substrate faces downwards. There is space between the fourth surface and the second surface, the first power chip is disposed between the first substrate and the second substrate, and the first substrate and the first power chip are fastened together. The first substrate and the first power chip are fastened in a plurality of manners. For example, the first substrate and the first power chip are directly fastened together, or the first power chip is packaged and then fastened to the first substrate. For example, the first power chip may be connected to the second substrate by using solder. The conductive part may electrically connect the first substrate and the second substrate. In the power structure shown in FIG. 18, the driver chip and the first power chip are disposed on different planes. The power structure is a three-dimensional structure. The conductive part may electrically connect the first substrate and the second substrate, to shorten a transmission path between the first substrate and the second substrate, and decrease a parasitic parameter of the power structure. Based on the power structure shown in FIG. 18, device miniaturization and a high integration degree of the power structure can be realized.

The first package body covers the second surface of the second substrate and the first power chip, and a packaging processes of the first package body and the foregoing second package body may be the same or different. After the first power chip on the second surface of the second substrate is packaged, the first package body is obtained. The first substrate is stuck on the first package body by using the adhesive film. Therefore, the first substrate and the first power chip may be fastened together by using the first package body and the adhesive film. A material and a thickness of the adhesive film are not limited.

It should be noted that in this embodiment of this application, a quantity of conductive parts in the power structure and a distribution location of the conductive parts are not limited, a quantity of driver chips in the power structure and a distribution location of the driver chips are not limited, and a quantity of first power chips in the power structure and a distribution location of the first power chips are not limited. Specifically, these may be determined with reference to an application scenario, and merely example descriptions are used herein.

In some embodiments of this application, as shown in FIG. 19, the power structure further includes a second package body. The second package body covers the first substrate, the second surface of the second substrate, the driver chip, and the power chip.

In some embodiments of this application, as shown in FIG. 20, the power structure further includes the conductive part; and the first end of the conductive part is connected to the second surface of the second substrate.

The second package body covers the first substrate, the second surface of the second substrate, the driver chip, the power chip, and the conductive part. A second end of the conductive part is exposed from the second package body.

The second package body is used to package an internal structure of the power structure. For example, the second package body is used to package the first substrate, the second surface of the second substrate, the driver chip, the first power chip, and the conducting wire, to obtain a packaged power structure. For another example, the second package body is used to package the space between the first substrate and the second substrate. Both the first power chip and the conducting wire are packaged in the second package body, to obtain a sealed power structure. For example, the power structure may be a three-dimensional high-density packaging structure in which two substrates in a dual substrate are interconnected by using the conductive part. After being packaged in the second package body, an end of the conductive part is exposed from the second package body. Therefore, the conductive part may be used for an electrical connection between the power structure and an external device.

In FIG. 20, that the power structure includes two conductive parts is used as an example. There may be one or more conductive parts. This is not limited herein.

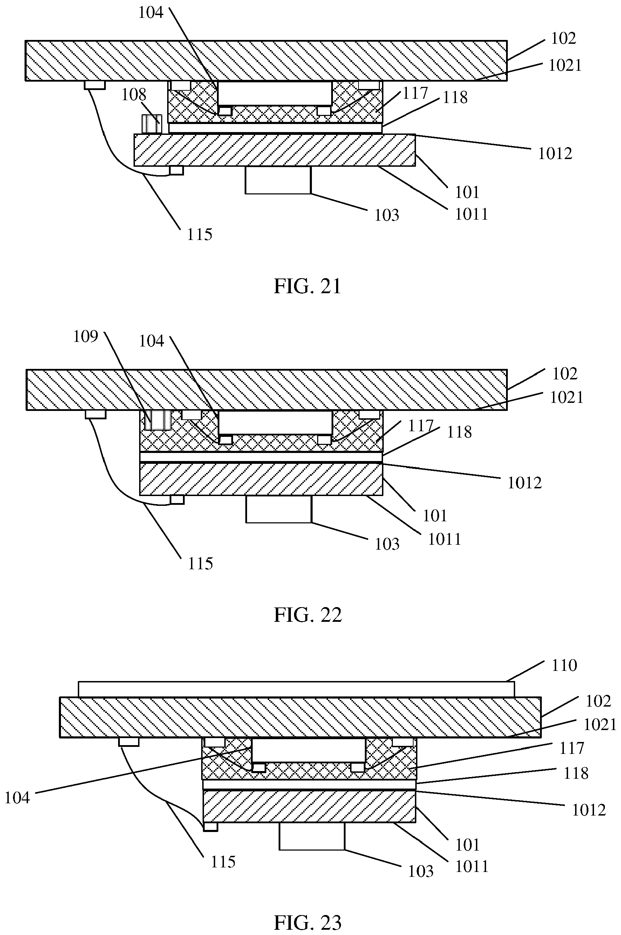

In some embodiments of this application, the power structure further includes an electronic element; and the electronic element is disposed on the first surface of the first substrate and/or the second surface of the second substrate. For ease of description and illustration, based on different distribution locations and connection relationships of the electronic element, the electronic element is respectively referred to as a first electronic element, a second electronic element, a third electronic element, and the like. For example, the electronic element is specifically the first electronic element. As shown in FIG. 21, the power structure further includes the first electronic element.

The first electronic element is disposed on the fourth surface and faces the second surface.

The first electronic element is disposed on the fourth surface of the first substrate, the driver chip is disposed on the first surface of the first substrate, the first electronic element may be disposed in the space between the first substrate and the second substrate, and the first electronic element and the first power chip may be distributed on different planes. Therefore, the power structure is a three-dimensional structure, to facilitate a miniaturization design of the power structure. A quantity of first electronic elements is not limited in this embodiment of this application.

It should be noted that, when the power structure further includes the first electronic element, the second package body covers the first substrate, the second surface, the driver chip, the first power chip, the conducting wire, the conductive part, and the first electronic element.

In some embodiments of this application, the driver chip is disposed on the first surface of the first substrate or built in the first substrate; and the power chip is disposed on the second surface of the second substrate. For example, the driver chip is located on the first surface and faces the second surface. The first surface is a surface that is of the first substrate and that is far away from the first package body. In the foregoing solution, the driver chip and the power chip are disposed between the first substrate and the second substrate, the driver chip and the power chip are disposed on different planes, and the power structure is a three-dimensional structure. Device miniaturization and a high integration degree of the power structure can be realized.

In a possible implementation, the driver chip is disposed on the second surface of the second substrate; and the power chip is disposed on the second surface of the second substrate. In the foregoing solution, the power structure includes a plurality of driver chips, some driver chips are disposed on the first substrate, and some other driver chips are disposed on the second substrate. The driver chip and the power chip are disposed between the first substrate and the second substrate, the driver chip and the power chip are disposed on different planes, and the power structure is a three-dimensional structure. Device miniaturization and a high integration degree of the power structure can be realized.

As shown in FIG. 22, the power structure further includes a second electronic element.

The second electronic element is disposed on the second surface and faces the fourth surface.

The second electronic element and the first power chip may be disposed side by side on the second surface of the second substrate, the second electronic element may be disposed in the space between the first substrate and the second substrate, and the second electronic element and the driver chip may be distributed on different planes. Therefore, the power structure is a three-dimensional structure, to facilitate a miniaturization design of the power structure. A quantity of second electronic elements is not limited in this embodiment of this application.

It should be noted that, when the power structure further includes the second electronic element, the second package body covers the first substrate, the second surface, the driver chip, the first power chip, the conductive part, and the second electronic element.

In some embodiments of this application, as shown in FIG. 23, the power structure further includes a heat dissipation module.

The heat dissipation module is disposed on a rear face of the second surface of the second substrate.

For example, the second substrate has a third surface, the second surface and the third surface of the second substrate are two opposite surfaces, and the third surface of the second substrate is an opposite face of the second substrate. For example, the third surface is used to dispose the heat dissipation module. The first power chip and the heat dissipation module are respectively disposed on different surfaces of the second substrate. The first power chip is packaged in the package body, but the heat dissipation module is not packaged in the package body. Therefore, the heat dissipation module may be configured to dissipate heat for the power structure. For example, the power structure may be a three-dimensional high-density and high-thermal conductivity packaging structure in which two substrates in a dual substrate are interconnected by using the conductive part.

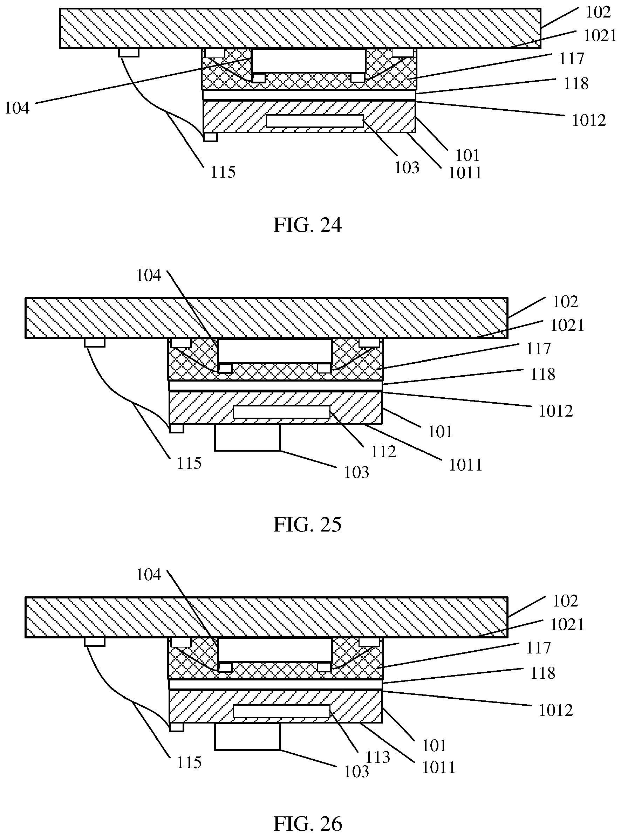

In some embodiments of this application, the driver chip may be built in the first substrate. For example, as shown in FIG. 24, the first substrate is a first embedded substrate.

The driver chip is disposed in the first embedded substrate.

As shown in FIG. 24, the driver chip is built in the first embedded substrate. Therefore, only the first power chip and the conductive part need to be disposed between the first embedded substrate and the second substrate, to further reduce a volume of the power structure, and facilitate a miniaturization design of the power structure.

In some embodiments of this application, the power chip may be built in the first substrate. For example, as shown in FIG. 25, the power structure further includes a second power chip.

The first substrate is a second embedded substrate.

The second power chip is disposed in the second embedded substrate.

As shown in FIG. 25, the driver chip may be disposed on the first surface of the second embedded substrate, and the second power chip is disposed in the second embedded substrate. Therefore, only the first power chip and the conductive part need to be disposed between the second embedded substrate and the second substrate, to further reduce a volume of the power structure, and facilitate a miniaturization design of the power structure.

It should be noted that a difference between FIG. 25 and FIG. 24 lies in that the embedded substrate includes different embedded units. For example, the driver chip is disposed in the first embedded substrate in FIG. 24, and the second power chip is disposed in the second embedded substrate in FIG. 25. The driver chip and the second power chip may alternatively be built simultaneously in the embedded substrate in the power structure. This is not limited herein.

In some embodiments of this application, the electronic element may be built in the first substrate. For example, as shown in FIG. 26, the power structure further includes a third electronic element.

The first substrate is a third embedded substrate.

The third electronic element is disposed in the third embedded substrate.

In FIG. 26, the driver chip may be disposed on the first surface of the third embedded substrate, and the third electronic element is disposed in the third embedded substrate. Therefore, only the first power chip and the conductive part need to be disposed between the third embedded substrate and the second substrate, to further reduce a volume of the power structure, and facilitate a miniaturization design of the power structure.

It should be noted that a difference between FIG. 25 and FIG. 26 lies in that the embedded substrate includes different embedded units. For example, the second power chip is disposed in the second embedded substrate in FIG. 25, and the third electronic element is disposed in the third embedded substrate in FIG. 26. The second power chip and the third electronic element may alternatively be built simultaneously in the embedded substrate in the power structure. This is not limited herein.

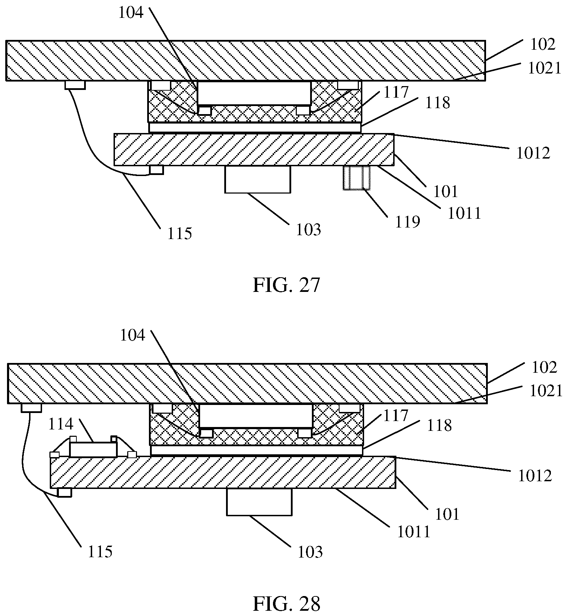

In some embodiments of this application, as shown in FIG. 27, the power structure further includes a fourth electronic element.

The fourth electronic element is disposed on the first surface of the first substrate.

The fourth surface and the first surface of the first substrate are two opposite surfaces, and the fourth surface of the first substrate is an opposite face of the first substrate. For example, the fourth surface is used to dispose the fourth electronic element. The fourth electronic element may be disposed on the first surface of the first substrate, and the fourth electronic element and the first power chip are distributed on different planes. Therefore, the power structure is a three-dimensional structure, to facilitate a miniaturization design of the power structure.

In some embodiments of this application, as shown in FIG. 27, the driver chip is located on the first surface of the first substrate.

The fourth surface and the first surface of the first substrate are two opposite surfaces, the driver chip may be disposed on the first surface of the first substrate, and the driver chip and the first power chip are distributed on different planes. Therefore, the power structure is a three-dimensional structure, to facilitate a miniaturization design of the power structure.

In some embodiments of this application, as shown in FIG. 28, the power structure further includes a third power chip.

The third power chip is located on the fourth surface and faces the second surface.

The power structure may include a plurality of power chips. For example, the power structure includes the first power chip and the third power chip, the first power chip is disposed on the second substrate, and the third power chip is disposed on the first substrate. The third power chip is disposed on the fourth surface of the first substrate, the third power chip may be disposed in the space between the first substrate and the second substrate, and the third power chip and the first power chip may be distributed on different planes. Therefore, the power structure is a three-dimensional structure, to facilitate a miniaturization design of the power structure.

The foregoing embodiment describes the power structure. The following describes an alternating current module provided in an embodiment of this application. The alternating current module includes the power structure shown in FIG. 18 to FIG. 28. The alternating current module has advantages of a small volume, a high integration degree, and a small parasitic parameter.

The following describes an energy device provided in an embodiment of this application. The energy device includes the power structure shown in FIG. 18 to FIG. 28; or
the energy device includes the foregoing alternating current module.

The energy device has advantages of a small volume, a high integration degree, and a small parasitic parameter.

The following describes a remote radio unit provided in an embodiment of this application. The remote radio unit includes the foregoing alternating current module. The remote radio unit has advantages of a small volume, a high integration degree, and a small parasitic parameter.

It can be learned from the example descriptions in the foregoing embodiments that, the second substrate has the second surface, the power chip is located on the second surface, and the first substrate is stuck on the first package body by using the adhesive film, so that the power chip is located between the first substrate and the second substrate. In addition, the driver chip is disposed on the first substrate. Therefore, the power chip and the driver chip are disposed on the two substrates, and the power chip and the driver chip belong to a structure in which the two substrates are stacked, to improve an integration degree of the power structure. Two ends of the conducting wire are respectively connected to the first substrate and the second substrate, and the conducting wire may be used to implement electrical transmission between the first substrate and the second substrate, to decrease a parasitic parameter of the power structure, and meet a requirement of the high-frequency and high-power field.

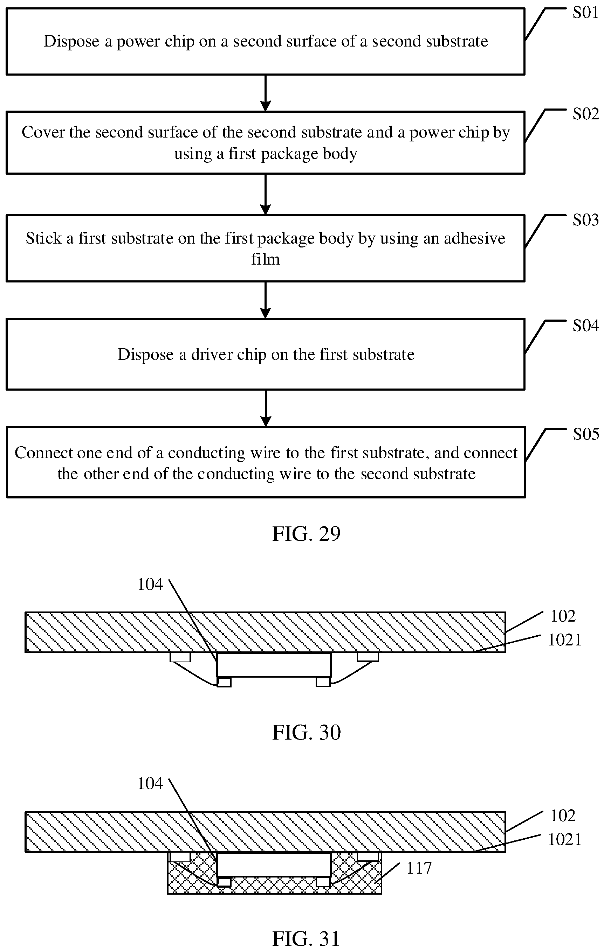

The following describes a method for preparing the power structure shown in FIG. 18 to FIG. 28. As shown in FIG. 29, the method mainly includes the following procedure:
S01: Dispose a power chip on a second surface of a second substrate.
S02: Cover the second surface of the second substrate and a power chip by using a first package body.
S03: Stick a first substrate on the first package body by using an adhesive film.
S04: Dispose a driver chip on the first substrate.
S05: Connect one end of a conducting wire to the first substrate, and connect the other end of the conducting wire to the second substrate.

In some embodiments of this application, the method further includes:
connecting a first end of a conductive part to the second surface of the second substrate.

In some embodiments of this application, the method further includes:
covering the first substrate, the second surface of the second substrate, the driver chip, the power chip, and the conductive part by using a second package body.

A second end of the conductive part is exposed from the second package body.

In some embodiments of this application, the disposing a driver chip on the first substrate includes:
disposing the driver chip on a first surface of the first substrate, or building the driver chip in the first substrate.

The disposing a power chip on a second surface of a second substrate includes:
disposing the power chip on the second surface of the second substrate.

In some embodiments of this application, the method further includes:
disposing an electronic element on the first surface of the first substrate and/or the second surface of the second substrate.

The first surface is a surface that is of the first substrate and that is far away from the first package body.

In some embodiments of this application, a heat dissipation module is disposed on a rear face of the second surface of the second substrate.

It can be understood that the power structure shown in FIG. 18 to FIG. 28 may be obtained in the method shown in FIG. 29. For descriptions of a process of preparing the power structure in this embodiment of this application, refer to the foregoing embodiments. Details are not described herein again in the method embodiment.

It can be learned from the example descriptions in the foregoing embodiments that, the second substrate has the second surface, the power chip is located on the second surface, and the first substrate is stuck on the first package body by using the adhesive film, so that the power chip is located between the first substrate and the second substrate. In addition, the driver chip is disposed on the first substrate. Therefore, the power chip and the driver chip are disposed on the two substrates, and the power chip and the driver chip belong to a structure in which the two substrates are stacked, to improve an integration degree of the power structure. Two ends of the conducting wire are respectively connected to the first substrate and the second substrate, and the conducting wire may be used to implement electrical transmission between the first substrate and the second substrate, to decrease a parasitic parameter of the power structure, and meet a requirement of the high-frequency and high-power field.

The power structure is described below by using an actual application scenario as an example.

The power structure provided in this embodiment of this application may be applied to a wireless 5G enhanced multiple-input multiple-output (multiple-input multiple-output) product, to improve a packaging integration degree of the power structure, and resolve problems of heat dissipation and a large parasitic parameter of a high-frequency and high-power device.

The power structure provided in this embodiment of this application is a three-dimensional high-density and high-thermal conductivity packaging structure in which two substrates in a dual substrate are interconnected by using the conductive part. A plurality of chips are stacked and molded, to improve a packaging integration degree. In addition, an upper substrate and a lower substrate are interconnected to shorten a signal transmission path. A heat dissipation structure is designed on the upper substrate in a stacking structure. The power structure is applicable to the high-frequency and high-power field.

As shown in FIG. 30 and FIG. 31, the power structure in this embodiment of this application includes: a lower substrate having a circuit function, an upper substrate having a heat dissipation function, a driver chip (or a chip having a driving function), a power chip, and a conducting wire. Optionally, the power structure may further include another required electronic element, the second package body, the first package body, and the conductive part.

In comparison with the embodiments in FIG. 16 and FIG. 17, as shown in FIG. 30, a packaging mode in which the two substrates in the dual substrate are snap-fitted is changed in this embodiment, the substrates are stacked and assembled, and the power chip is assembled on the upper substrate having the heat dissipation function. Then, the power chip part is molded, to obtain the first package body, as shown in FIG. 31. A layer of adhesive film is stuck on a surface of the first package body, a lower substrate on which the driver chip is stuck is assembled on the first package body, an electrical interconnection process is completed based on a requirement, and finally, the second package body is used for packaging, to obtain the power structure shown in FIG. 18. The conductive part assembled on the upper substrate is used for signal transmission of the power chip, and the conductive part exposed after molding is used for an electrical interconnection between the power structure and an outside.

In this embodiment of this application, the power structure is a dual-substrate three-dimensional packaging structure in which a plurality of chips are stacked, to improve packaging density, and reduce a packaging dimension. The upper substrate having the heat dissipation function provides a good heat dissipation channel, to resolve a difficulty of heat dissipation of three-dimensional packaging. In the packaging structure in which the upper substrate and the lower substrate are stacked, a parasitic parameter is decreased. An application extends to the high-frequency field. In addition, there is no direct signal transmission between the upper substrate and an outside, to play an electrical isolation role.

In addition, it should be noted that the described apparatus embodiments are merely examples. The units described as separate parts may or may not be physically separate, and parts displayed as units may or may not be physical units, that is, may be located in one place, or may be distributed on a plurality of network units. Some or all the modules may be selected according to an actual need to achieve the objectives of the solutions of the embodiments. In addition, in the accompanying drawings of the apparatus embodiments provided in this application, connection relationships between modules indicate that the modules have communication connections with each other, which may be specifically implemented as one or more communications buses or signal cables.

Based on the description of the foregoing implementations, a person skilled in the art may clearly understand that this application may be implemented by using software in combination with necessary universal hardware, or certainly, may be implemented by using dedicated hardware, including a dedicated integrated circuit, a dedicated CPU, a dedicated memory, a dedicated component, or the like. Generally, any function that can be completed by using a computer program can be easily implemented by using corresponding hardware. Moreover, a specific hardware structure used to implement a same function may be in various forms, for example, in a form of an analog circuit, a digital circuit, a dedicated circuit, or the like. However, as for this application, software program implementation is a better implementation in most cases. Based on such an understanding, the technical solutions of this application essentially or the part contributing to the prior art may be implemented in a form of a software product. The computer software product is stored in a readable storage medium, such as a floppy disk of a computer, a USB flash drive, a removable hard disk, a ROM, a RAM, a magnetic disk, or an optical disc, and includes several instructions for instructing a computer device (which may be a personal computer, a server, a network device, or the like) to perform the methods in the embodiments of this application.

All or some of the foregoing embodiments may be implemented by using software, hardware, firmware, or any combination thereof. When software is used to implement the embodiments, all or some of the embodiments may be implemented in a form of a computer program product.

The computer program product includes one or more computer instructions. When the computer program instructions are loaded and executed on a computer, all or some of the procedures or the functions according to the embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, a computer, a server, or a data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid State Disk, SSD)), or the like.

## Claims

1. A power structure, wherein the power structure comprises a first substrate (101), a second substrate (102), a driver chip (103), a power semiconductor chip (104), and a conductive part (105), wherein:
the power semiconductor chip (104) is a chip that generates power in a powered-on state; the driver chip (103) is a chip component configured to drive the power semiconductor chip (104);
a first surface of the first substrate (1011) and a second surface of the second substrate (1021) are disposed opposite to each other;
a first end of the conductive part (1051) is connected to the first surface (1011), and a second end of the conductive part (1052) is connected to the second surface (1021);
the driver chip (103) is disposed on the first substrate (101); and
the power semiconductor chip (104) is disposed on the second substrate (102);
the second substrate (102) is a substrate having a heat dissipation function; and wherein:
the heat dissipation function comprises the second substrate (102) being a direct bonding copper; or,
the heat dissipation function comprises a heat dissipation module (110) disposed on the second substrate (102);
wherein the power chip and the heat dissipation module are respectively disposed on different surfaces of the second substrate.

2. The power structure according to claim 1, wherein the power structure further comprises a package body (106), and the package body covers the first surface of the first substrate (1011), the second substrate (102), the driver chip (103), the power semiconductor chip (104), and the conductive part (105).

3. The power structure according to claim 1 or 2, wherein
The driver chip (103) is disposed on the first surface of the first substrate (1011) or built in the first substrate (101); and
the power semiconductor chip (104) is disposed on the second surface of the second substrate (1021).

4. The power structure according to any one of claims 1 to 3, wherein the first end (1051) is soldered to the first surface (1011), and the second end (1052) is soldered to the second surface (1021).

5. The power structure according to any one of claims 1 to 4, wherein the power structure further comprises an electronic element, wherein
the electronic element is disposed on the first surface of the first substrate (1011) and/or the second surface of the second substrate (1021).

6. The power structure according to any one of claims 1 to 5, wherein
the heat dissipation module is disposed on a rear face of the second surface (1024) of the second substrate.

7. A power structure preparation method, comprising:
disposing a power semiconductor chip (104) on a second surface of a second substrate (1021), wherein the power semiconductor chip (104) is a chip that can generate power in a powered-on state;
covering the second surface of the second substrate (1021) and the power semiconductor chip (104) by using a first package body (117);
sticking a first substrate (101) on the first package body (117) by using an adhesive film (118);
disposing a driver chip (103) on the first substrate (101), wherein the driver chip (103) is a chip component configured to drive the power semiconductor chip (104); and
connecting one end of a conducting wire (115) to the first substrate (101), and connecting the other end of the conducting wire (115) to the second substrate (102),
wherein the second substrate (102) is a substrate having a heat dissipation function; and wherein:
the heat dissipation function comprises the second substrate being a direct bonding copper; or,
the heat dissipation function comprises a heat dissipation module disposed on the second substrate;
wherein the power chip and the heat dissipation module are respectively disposed on different surfaces of the second substrate.

8. The method according to claim 7, wherein the method further comprises:
connecting a first end of a conductive part (1051) to the second surface of the second substrate (1021).

9. The method according to claim 8, wherein the method further comprises:
covering the first substrate (101), the second surface of the second substrate (1021), the driver chip (103), the power semiconductor chip (104), and the conductive part (105) by using a second package body, wherein
a second end of the conductive part (1051) is exposed from the second package body.

10. The method according to any one of claims 7 to 9, wherein the disposing a driver chip (103) on the first substrate (101) comprises:
disposing the driver chip (103) on a first surface of the first substrate (1011), or building the driver chip (103) in the first substrate (101); and
the disposing a power semiconductor chip (104) on a second surface of a second substrate (1021) comprises:
disposing the power semiconductor chip (104) on the second surface of the second substrate (1021).

11. The method according to any one of claims 7 to 10, wherein the method further comprises:
disposing an electronic element on the first surface of the first substrate (1011) and/or the second surface of the second substrate (1021), wherein
the first surface is a surface that is of the first substrate and that is far away from the first package body.

12. An alternating current module, wherein the alternating current module comprises the power structure according to any one of claims 1 to 6.

13. An energy device, wherein the energy device comprises the power structure according to any one of claims 1 to 6; or
the energy device comprises the alternating current module according to claim 12.

14. A remote radio unit, wherein the remote radio unit comprises the alternating current module according to claim 13.

## Patentansprüche

1. Leistungsstruktur, wobei die Leistungsstruktur ein erstes Substrat (101), ein zweites Substrat (102), einen Treiberchip (103), einen Leistungshalbleiterchip (104) und einen leitenden Teil (105) umfasst, wobei:
der Leistungshalbleiterchip (104) ein Chip ist, der im eingeschalteten Zustand Strom erzeugt; der Treiberchip (103) eine Chipkomponente ist, die zum Antreiben des Leistungshalbleiterchips (104) konfiguriert ist;
eine erste Oberfläche des ersten Substrats (1011) und eine zweite Oberfläche des zweiten Substrats (1021) einander gegenüberliegend angeordnet sind;
ein erstes Ende des leitenden Teils (1051) mit der ersten Oberfläche (1011) verbunden ist und ein zweites Ende des leitenden Teils (1052) mit der zweiten Oberfläche (1021) verbunden ist;
der Treiberchip (103) auf dem ersten Substrat (101) angeordnet ist; und
der Leistungshalbleiterchip (104) auf dem zweiten Substrat (102) angeordnet ist;
das zweite Substrat (102) ein Substrat mit einer Wärmeableitungsfunktion ist; und wobei:
die Wärmeableitungsfunktion umfasst, dass das zweite Substrat (102) ein direkt verbundenes Kupfer ist; oder
die Wärmeableitungsfunktion ein Wärmeableitungsmodul (110) umfasst, das auf dem zweiten Substrat (102) angeordnet ist;
wobei der Leistungschip und das Wärmeableitungsmodul jeweils auf unterschiedlichen Oberflächen des zweiten Substrats angeordnet sind.

2. Leistungsstruktur nach Anspruch 1, wobei die Leistungsstruktur ferner einen Gehäusekörper (106) umfasst und der Gehäusekörper die erste Oberfläche des ersten Substrats (1011), des zweiten Substrats (102), dem Treiberchip ( 103), den Leistungshalbleiterchip (104) und das leitende Teil (105) bedeckt.

3. Leistungsstruktur nach Anspruch 1 oder 2, wobei
der Treiberchip (103) auf der ersten Oberfläche des ersten Substrats (1011) angeordnet oder in das erste Substrat (101) eingebaut ist; und
der Leistungshalbleiterchip (104) auf der zweiten Oberfläche des zweiten Substrats (1021) angeordnet ist.

4. Leistungsstruktur nach einem der Ansprüche 1 bis 3, wobei das erste Ende (1051) mit der ersten Oberfläche (1011) verlötet ist und das zweite Ende (1052) mit der zweiten Oberfläche (1021) verlötet ist.

5. Leistungsstruktur nach einem der Ansprüche 1 bis 4, wobei die Leistungsstruktur ferner ein elektronisches Element umfasst, wobei
das elektronische Element auf der ersten Oberfläche des ersten Substrats (1011) und/oder der zweiten Oberfläche des zweiten Substrats (1021) angeordnet ist.

6. Leistungsstruktur nach einem der Ansprüche 1 bis 5, wobei das Wärmeableitungsmodul auf einer Rückseite der zweiten Oberfläche (1024) des zweiten Substrats angeordnet ist.

7. Leistungsstrukturherstellungsverfahren, umfassend:
Anordnen eines Leistungshalbleiterchips (104) auf einer zweiten Oberfläche eines zweiten Substrats (1021), wobei der Leistungshalbleiterchip (104) ein Chip ist, der in einem eingeschalteten Zustand Leistung erzeugen kann;
Bedecken der zweiten Oberfläche des zweiten Substrats (1021) und des Leistungshalbleiterchips (104) unter Verwendung eines ersten Gehäusekörpers (117);
Aufkleben eines ersten Substrats (101) auf den ersten Gehäusekörper (117) unter Verwendung einer Klebefolie (118);
Anordnen eines Treiberchips (103) auf dem ersten Substrat (101), wobei der Treiberchip (103) eine Chipkomponente ist, die zum Steuern des Leistungshalbleiterchips (104) konfiguriert ist; und
Verbinden eines Endes eines leitenden Drahtes (115) mit dem ersten Substrat (101) und Verbinden des anderen Endes des leitenden Drahtes (115) mit dem zweiten Substrat (102),
wobei zweite Substrat (102) ein Substrat mit einer Wärmeableitungsfunktion ist; und wobei:
die Wärmeableitungsfunktion umfasst, dass das zweite Substrat ein direkt verbundenes Kupfer ist; oder
die Wärmeableitungsfunktion ein Wärmeableitungsmodul umfasst, das auf dem zweiten Substrat angeordnet ist; wobei der Leistungschip und das Wärmeableitungsmodul jeweils auf unterschiedlichen Oberflächen des zweiten Substrats angeordnet sind.

8. Verfahren nach Anspruch 7, wobei das Verfahren ferner Folgendes umfasst:
Verbinden eines ersten Endes eines leitenden Teils (1051) mit der zweiten Oberfläche des zweiten Substrats (1021).

9. Verfahren nach Anspruch 8, wobei das Verfahren ferner Folgendes umfasst:
Bedecken des ersten Substrats (101), der zweiten Oberfläche des zweiten Substrats (1021), des Treiberchips (103), des Leistungshalbleiterchips (104) und des leitenden Teils (105) unter Verwendung eines zweiten Gehäusekörpers, wobei
ein zweites Ende des leitenden Teils (1051) von dem zweiten Gehäusekörper frei liegt.

10. Verfahren nach einem der Ansprüche 7 bis 9, wobei das Anordnen eines Treiberchips (103) auf dem ersten Substrat (101) Folgendes umfasst:
Anordnen des Treiberchips (103) auf einer ersten Oberfläche des ersten Substrats (1011) oder Einbauen des Treiberchips (103) in das erste Substrat (101); und
wobei das Anordnen eines Leistungshalbleiterchips (104) auf einer zweiten Oberfläche eines zweiten Substrats (1021) umfasst:
Anordnen des Leistungshalbleiterchips (104) auf der zweiten Oberfläche des zweiten Substrats (1021).

11. Verfahren nach einem der Ansprüche 7 bis 10, wobei das Verfahren ferner Folgendes umfasst:
Anordnen des elektronischen Elements auf der ersten Oberfläche des ersten Substrats (1011) und/oder der zweiten Oberfläche des zweiten Substrats (1021), wobei
die erste Oberfläche eine Oberfläche des ersten Substrats ist und weit von dem ersten Gehäusekörper entfernt ist.

12. Wechselstrommodul, wobei das Wechselstrommodul die Leistungsstruktur nach einem der Ansprüche 1 bis 6 umfasst.

13. Energievorrichtung, wobei die Energievorrichtung die Leistungsstruktur nach einem der Ansprüche 1 bis 6 umfasst;
oder
die Energievorrichtung das Wechselstrommodul nach Anspruch 12 umfasst.

14. Entfernte Funkeinheit, wobei die entfernte Funkeinheit das Wechselstrommodul nach Anspruch 13 umfasst.

## Revendications

1. Structure d'alimentation, dans laquelle la structure d'alimentation comprend un premier substrat (101), un second substrat (102), une puce pilote (103), une puce semi-conductrice de puissance (104) et une partie conductrice (105), dans laquelle :
la puce semi-conductrice de puissance (104) est une puce qui génère de la puissance dans un état sous tension ; la puce pilote (103) est un composant de puce configuré pour piloter la puce semi-conductrice de puissance (104) ;
une première surface du premier substrat (1011) et une seconde surface du second substrat (1021) sont placées à l'opposé l'une de l'autre ;
une première extrémité de la partie conductrice (1051) est connectée à la première surface (1011), et une seconde extrémité de la partie conductrice (1052) est connectée à la seconde surface (1021) ;
la puce pilote (103) est placée sur le premier substrat (101) ; et
la puce semi-conductrice de puissance (104) est placée sur le second substrat (102) ;
le second substrat (102) est un substrat ayant une fonction de dissipation thermique ; et dans laquelle :
la fonction de dissipation thermique comprend le second substrat (102) qui est un cuivre à liaison directe ; ou,
la fonction de dissipation thermique comprend un module de dissipation thermique (110) placé sur le second substrat (102) ;
dans laquelle la puce de puissance et le module de dissipation thermique sont respectivement placés sur différentes surfaces du second substrat.

2. Structure d'alimentation selon la revendication 1, dans laquelle la structure d'alimentation comprend en outre un corps de boîtier (106), et le corps de boîtier recouvre la première surface du premier substrat (1011), le second substrat (102), la puce pilote (103), la puce semi-conductrice de puissance (104) et la partie conductrice (105).

3. Structure d'alimentation selon la revendication 1 ou 2, dans laquelle
la puce pilote (103) est placée sur la première surface du premier substrat (1011) ou intégrée dans le premier substrat (101) ; et
la puce semi-conductrice de puissance (104) est placée sur la seconde surface du second substrat (1021).

4. Structure d'alimentation selon l'une quelconque des revendications 1 à 3, dans laquelle la première extrémité (1051) est soudée à la première surface (1011), et la seconde extrémité (1052) est soudée à la seconde surface (1021).

5. Structure d'alimentation selon l'une quelconque des revendications 1 à 4, dans laquelle la structure d'alimentation comprend en outre un élément électronique, dans laquelle
l'élément électronique est placé sur la première surface du premier substrat (1011) et/ou la seconde surface du second substrat (1021).

6. Structure d'alimentation selon l'une quelconque des revendications 1 à 5, dans laquelle
le module de dissipation thermique est placé sur une face arrière de la seconde surface (1024) du second substrat.

7. Procédé de préparation de structure d'alimentation, comprenant :
le placement d'une puce semi-conductrice de puissance (104) sur une seconde surface d'un second substrat (1021), dans lequel la puce semi-conductrice de puissance (104) est une puce qui peut générer de la puissance dans un état sous tension ;
le fait de recouvrir la seconde surface du second substrat (1021) et la puce semi-conductrice de puissance (104) à l'aide d'un premier corps de boîtier (117) ;
le collage d'un premier substrat (101) sur le premier corps de boîtier (117) à l'aide d'un film adhésif (118) ;
le placement d'une puce pilote (103) sur le premier substrat (101), dans lequel la puce pilote (103) est un composant de puce configuré pour piloter la puce semi-conductrice de puissance (104) ; et
la connexion d'une extrémité d'un fil conducteur (115) au premier substrat (101), et la connexion de l'autre extrémité du fil conducteur (115) au second substrat (102),
dans lequel le second substrat (102) est un substrat ayant une fonction de dissipation thermique ; et dans lequel :
la fonction de dissipation thermique comprend le second substrat qui est un cuivre à liaison directe ; ou,
la fonction de dissipation thermique comprend un module de dissipation thermique placé sur le second substrat ; dans lequel la puce de puissance et le module de dissipation thermique sont respectivement placés sur différentes surfaces du second substrat.

8. Procédé selon la revendication 7, dans lequel le procédé comprend en outre :
la connexion d'une première extrémité d'une partie conductrice (1051) à la seconde surface du second substrat (1021).

9. Procédé selon la revendication 8, dans lequel le procédé comprend en outre :
le fait de recouvrir le premier substrat (101), la seconde surface du second substrat (1021), la puce pilote (103), la puce semi-conductrice de puissance (104) et la partie conductrice (105) à l'aide d'un second corps de boîtier, dans lequel
une seconde extrémité de la partie conductrice (1051) est exposée depuis le second corps de boîtier.

10. Procédé selon l'une quelconque des revendications 7 à 9, dans lequel le placement d'une puce pilote (103) sur le premier substrat (101) comprend :
le placement de la puce pilote (103) sur une première surface du premier substrat (1011), ou l'intégration de la puce pilote (103) dans le premier substrat (101) ; et
le placement d'une puce semi-conductrice de puissance (104) sur une seconde surface d'un second substrat (1021) comprend :
le placement de la puce semi-conductrice de puissance (104) sur la seconde surface du second substrat (1021).

11. Procédé selon l'une quelconque des revendications 7 à 10, dans lequel le procédé comprend en outre :
le placement d'un élément électronique sur la première surface du premier substrat (1011) et/ou la seconde surface du second substrat (1021), dans lequel
la première surface est une surface qui appartient au premier substrat et qui est éloignée du premier corps de boîtier.

12. Module à courant alternatif, dans lequel le module à courant alternatif comprend la structure d'alimentation selon l'une quelconque des revendications 1 à 6.

13. Dispositif énergétique, dans lequel le dispositif énergétique comprend la structure d'alimentation selon l'une quelconque des revendications 1 à 6 ; ou
le dispositif énergétique comprend le module à courant alternatif selon la revendication 12.

14. Unité radio distante, dans laquelle l'unité radio distante comprend le module à courant alternatif selon la revendication 13.
